(19) Europäisches Patentamt
European Patent Office
Office européen des brevets

(11) Publication number: **0 057 947**
**A1**

# (12) EUROPEAN PATENT APPLICATION

(21) Application number: 82200059.2

(22) Date of filing: 19.01.82

(51) Int. Cl.$^3$: G 03 C 5/54
G 03 C 1/68, G 03 C 1/46
G 03 C 5/00

(30) Priority: 30.01.81 GB 8102993

(43) Date of publication of application:
18.08.82 Bulletin 82/33

(84) Designated Contracting States:
BE CH DE FR GB IT LI NL SE

(71) Applicant: AGFA-GEVAERT naamloze vennootschap
Septestraat 27
B-2510 Mortsel(BE)

(72) Inventor: Daems, Eddie Roza
Eigenhaard 30
B-2410 Herentals(BE)

(72) Inventor: Leenders, Luc Herwig
Broekstraat 17
B-2450 Tielen(BE)

(54) **Imaging process including silver-complex diffusion transfer and materials therefor suited for use in the production of identification documents.**

(57) An imaging process comprising the steps of:

(1) image-wise photoexposing a photopolymerizable layer of a first photographic material to form an image-wise change of permeability for dissolved silver complexes therein,

(2) image-wise photoexposing a silver halide emulsion layer forming part of the said first photographic material or of a second photographic material,

(3) developing the image-wise exposed silver halide emulsion layer in the presence of a developing agent and a silver halide solvent acting as silver halide complexing agent,

(4) transferring by diffusion complexed silver halide into an image-receiving layer forming part of said first photographic material containing developing nuclei acting as physical development catalyst and developing a silver image in the image-receiving layer by reduction of the transferred complexed silver halide, wherein step (1) proceeds either before or after the formation of the silver image in the said image-receiving layer.

This process is suitable for use in the production of identification documents.

EP 0 057 947 A1

Imaging process including silver-complex diffusion transfer and materials therefor suited for use in the production of identification documents.

The present invention relates to an imaging process including silver-complex diffusion transfer and materials therefor suited for use in the production of identification documents.

The evolution of our present-day society with the increasing necessity of identification of persons through passports, licences, buyer's cards, key cards, membership cards, etc. has created the need for an identification document that cannot be forged.

On the more reliable certificates of identity not only the name, personal data and the signature of the bearer are recorded but also his picture i.e. portrait by which he can be identified at first glance. One of the main problems is to provide an identification card in which the portrait cannot be fraudulently altered or substituted by an other one.

According to US P 4,011,570 of Emile Frans Stiévenart and Hugo Frans Deconinck, issued March 8, 1977, the portrait and the personal data are simultaneously transferred through the DTR-process on one and the same receptor sheet so that when making the identification card discrepancies between the personal picture and the data are absolutely impossible. Although said receptor sheet containing the personal data and portrait are laminated in a plastic cover, so that it is protected against damage and dirt it may be possible to a skilled forger to open the sealing without great damage and to reach the portrait to bleach it and to substitute it by an other one.

From US P 3,236,644 of Paul, B.Gilman, Jr. and Ralph W.Baxendale, issued February 22, 1966, it is known to produce a silver image in an information-wise irradiated photopolymerizable layer by overall applying thereto solubilized complexed silver halide, usually by diffusion transfer from an unexposed silver halide emulsion layer. According to a particular embodiment involving a reversal process a negative silver image is produced in a receiving layer from a negative original (or a positive from a positive original).

It is an object of the present invention to provide an imaging process that offers a better protection against forgery of identity cards and enables to detect fraudulent substitution of pictures.

According to the present invention the permeability change obtained in an information-wise photoexposed photopolymerizable layer is used to control the optical density of a silver image formed by the silver complex diffusion transfer reversal (DTR) process.

The effect of the invention is to provide a "marker image" associated with the image which is to be protected. In one procedure for carrying out the invention, the marker image is present with the image to be protected, but is removed and cannot be reinstated if a fraudulent image is applied. In another procedure the marker image is initially absent, but is produced if a fraudulent DTR-image is applied.

The imaging process of the present invention comprises the steps :

(1) image-wise exposing a photopolymerizable layer of a first photographic material to form therein an image-wise change of permeability for dissolved silver complexes,

(2) image-wise exposing a silver halide emulsion layer forming part either of the said first photographic material, or of a second photographic material,

(3) developing the image-wise exposed silver halide emulsion layer in the presence of a developing agent and a silver halide solvent acting as a silver halide complexing agent,

(4) transferring by diffusion dissolved complexed silver halide from said emulsion layer to an image-receiving layer forming part of said first photographic material and containing developing nuclei acting as physical development catalyst and which stand initially in water permeable relationship with the photopolymerizable layer, and developing a silver image in the image receiving layer by reduction of the transferred complexed silver halide, wherein step (1) is carried out either before or after the formation of the silver image in the said image-receiving layer.

In a particular embodiment the photopolymerizable layer contains the developing nuclei and thus forms the said image-receiving layer.

The imaging process is suited for being carried out with a two-sheet system in which a separate photographic silver halide emulsion material acting as said second photographic material is image-wise exposed and under developing conditions in the presence of a silver halide complexing agent is contacted with a said first

photographic material containing said photopolymerizable layer and developing nuclei thereby acting as image-receiving material, which after formation therein of a silver image is separated from said photographic silver halide emulsion material.

In the two-sheet system the present process more particularly comprises the steps of :

(1) providing a photographic negative working silver halide emulsion material,
(2) providing a separate image-receiving material suitable for carrying out the silver complex diffusion transfer reversal process said receiving material containing developing nuclei dispersed in a continuous water-permeable binder medium of a water-permeable photopolymerizable layer or containing said nuclei adjacent said photopolymerizable layer in water-permeable relationship therewith, characterized in that the process also comprises the steps of :
(3) image-wise exposing the photographic negative working silver halide emulsion material,
(4) developing the image-wise exposed silver halide emulsion material and contacting the developed exposed silver halide emulsion material with the image-receiving material in the presence of an alkaline liquid containing the silver halide complexing agent and in the presence of at least one developing agent thereby transferring dissolved unexposed and complexed silver halide by diffusion into the image-receiving material and producing therein a silver image,
(5) separating the silver halide emulsion material from the receiving material, and
(6) before or after producing a silver image in the image-receiving material image-wise exposing the photopolymerizable layer to change image-wise the permeability of said layer for dissolved complexed silver halide.

The process of the present invention can also be carried out with a monosheet system wherein both the photopolymerisable layer, the developing nuclei containing layer and the silver halide emulsion layer form part of the same photographic material the said monosheet photographic material thus acting as image-receiving material for the

DTR-image.

According to one embodiment in the monosheet system use is made of a recording material comprising on a transparent support in the order given :

(1) a water-permeable photopolymerizable layer of which the water-permeability can be changed image-wise by image-wise exposure thereof and containing development nuclei for complexed silver halide, or
   (1a) a layer containing development nuclei for complexed silver halide, and in water permeable relationship therewith
   (1b) a water-permeable photopolymerizable layer of which the water-permeability can be changed image-wise by image-wise exposure thereof,
(2) an opaque layer in water-permeable relationship with the photopolymerizable layer, and
(3) a silver halide emulsion layer.

The opaque layer precludes the detection by the eye of a silver image formed in the silver halide emulsion layer (3) when viewed from the side of the transparent support. The opaque layer contains e.g. white pigments such as titanium dioxide.

According to another embodiment in the monosheet system use is made of a recording material comprising on a transparent support the above layers in the reverse order given i.e. first layer (3), on top thereof layer (2) and thereover layer (1) or layers (1b) and (1a).

Examples of opaque pigment layers suited for the above purpose are described in the German Auslegeschrift 1,961,030, filed December 5, 1969 by Gevaert-Agfa N.V., in the German Offenlegungsschrift 1,772,603 filed June 7, 1968 by Gevaert-Agfa N.V., and in the United States Patent Specification 3,928,037 of Louis Maria De Haes and Hans-Georg Völz, issued December 23, 1975.

The above process preferably includes also an information-stabilization step.

In the embodiment wherein the image-wise exposure of the photopolymerizable layer precedes the DTR-process, the permeability pattern in the photopolymerizable layer can be destroyed after its use in the diffusion modulation of complexed silver halide by overall exposing to actinic radiation the photopolymerizable layer after

carrying out the DTR-process. Hereby the differentiation in permeability in the photopolymerizable layer is no longer available and a second DTR-process, e.g. carried out by a forger after bleaching the first DTR-image cannot proceed according to the firstly applied permeability pattern.

In the embodiment wherein the image-wise photo-exposure of the photopolymerizable layer proceeds after a DTR-image e.g. a portrait is formed, the permeability pattern can be stabilized e.g. (1) by removing still polymerizable monomer portions with a solvent or reagent therefor, (2) by inactivating or extracting photoinitiator contained in the photopolymerizable layer, (3) by washing-off the still water-soluble or alkali-soluble portions of a photopolymerizable layer when the latter is applied as covering layer over a layer containing developing nuclei, or (4) by incorporating a photopolymerization inhibitor in the photopolymerizable layer.

The embodiment wherein the image-wise photo-exposure of the photopolymereizable layer proceeds after a picture e.g. portrait through the DTR-process is produced, is particularly suited for preventing forgery of an identification document. Indeed, if afterwards a fraudulent substitution of the picture would be tried by first bleaching the original silver image and then carrying out the silver complex DTR-process again with a second image-wise exposed silver halide emulsion layer material the previously photoexposed areas of the photopolymerizable layer will become visible through differences in silver image density so that picture-substitution is recognizable.

In order to avoid staining it is recommended to rinse the image-receiving material with water after forming therein the silver image.

Photopolymerizable layers of which the said permeability can be controlled by photoexposure may be divided into two classes viz. these containing a hydrophilic colloid binder wherein a photopolymerizable composition is homogeneously dissolved and those containing a hydrophilic colloid binder wherein a photopolymerizable composition is homogeneously dispersed.

According to an embodiment of the first class the photosensitive photopolymerizable layer includes a homogeneous mixture of a

hydrophilic colloid binder and at least one water-soluble ethylenically unsaturated monomeric component dissolved in said binder, said mixture having uniformly distributed therethrough a photoinitiator for initiating the polymerization of said monomeric component on photoexposure with actinic light.

In this embodiment the photopolymerizable layer may contain development nuclei for complexed silver halide which are homogeneously distributed through said binder.

Optionally in this embodiment the photocatalyst and the developing nuclei are one and the same compound as described in the already mentioned US P 3,236,644.

According to an embodiment of the second class the photosensitive photopolymerizable layer includes a hydrophilic colloid binder having uniformly dispersed therethrough a phase containing

(1) at least one water-insoluble ethylenically unsaturated monomer being capable of forming a polymer by free radical-initiated chain-propagating addition polymerization, and

(2) at least one free-radical producing compound or composition activatable by actinic light acting as polymerization-photoinitiator(s).

Useful compositions of that type are disclosed e.g. in the US P 3,718,473 of Joseph Edmund Gervay and Peter Walker, issued February 27, 1973.

In this embodiment too the photopolymerizable layer may contain uniformly dispersed through the binder developing nuclei for complexed silver halide.

Photopolymerizable layers containing the water-insoluble polymerizable monomer(s) dispersed in the hydrophilic colloid binder are preferred because, during DTR-processing said water-insoluble polymerizable monomer(s) including photoinitiator(s) do not dissolve and do not leach out of the material as is the case with the water-soluble monomers homogeneously dissolved in the hydrophilic colloid binder. In the latter case the concentration of water-soluble monomer(s) and photoinitiator(s) has to be levelled up again, which may proceed by soaking after DTR-processing the material containing the photopolymerizable layer in an appropriate solution of monomer(s) and photoinitiator(s).

The monomeric components for use in the photopolymerizable layer of the above first embodiment are e.g. water-soluble addition polymerizable ethylenically-unsaturated vinyl or vinylidene compounds, for example, water-soluble acrylic monomers, such as acrylic acid and water-soluble derivatives of acrylic acid e.g. methacrylic acid, acrylamide, N,N-methylene bisacrylamide, metal acrylates, acrylonitrile, vinylpyrrolidone, vinylpyridines and quaternary salts thereof. Of these monomers, the acrylamides and metal acrylates e.g. calcium diacrylate were found to be particularly suitable for producing homogeneous mixtures with non-light-sensitive hydrophilic binding agents such as for example gelatin, casein, zein, ethyl cellulose, cellulose acetate phthalate, polyvinylpyrrolidinone and polyethylene glycols having a molecular weight between 4000 and 20,000.

Suitable binder concentrations are in the range of 5 percent to about 60 percent by weight of the total weight of the photopolymerizable layer.

Suitable photoinitiator and photoinitiator compositions for initiating the polymerization of the above water-soluble monomers upon exposure to actinic light are described e.g. by Kurt I.Jacobson and Ralph E.Jacobson in "Imaging Systems", The Focal Press London and New York 1st ed. (1976) p. 185-198. An example of such photoinitiator composition for the photopolymerization of acrylamide and/or barium diacrylate is a mixture of sodium p-toluene sulphinate and methylene blue optionally containing 4-diazodiphenylamine sulphate to form diphenylamine free radicals. Water-soluble photolabile compounds such as 4,5-diphenyl, 5-oxo, 4-alkoxy valeric acid alkali metal salts suitable as photoinitiator are described in the published Dutch Patent Application 71/06 311 filed May 7, 1971 by Farbenfabriken Bayer A.G.

Suitable photoinitiator concentrations can be found by a series of tests with increasing amounts of photoinitiator(s) but amounts ranging of 0.005 percent to about 10 percent by weight with respect to the total weight of the photopolymerizable layer are normal.

The thickness of photopolymerizable layers of said first embodiment may vary within wide limits, but is usually in the range of 0.5 to 25 μm.

The water-insoluble monomers for use in the photopolymerizable layer of the above second embodiment are e.g. unsaturated esters of polyols and particularly such esters of the alpha-methylene carboxylic acids e.g. ethylene glycol diacrylate, diethylene glycol diacrylate, glycerol diacrylate, glycerol triacrylate and especially pentaerythritol tetraacrylate and pentaerythritol tetramethacrylate.

Free-radical producing photoinitiator compounds suited for use in admixture with said monomers are biimidazolyl compounds substituted in the 2, 4 and 5-position with aromatic groups e.g. phenyl groups including substituted phenyl groups. Examples of such compounds are 2,4,5-triphenylimidazolyl dimers consisting of two lophine radicals bound together by a single covalent bond and derivatives thereof described in the United Kingdom Patent Specifications nos. 997,396 filed March 21, 1963 by E.I.du Pont de Nemours and 1,047,569 filed October 18, 1963 by E.I.du Pont de Nemours. These photoinitiators can be used advantegeously in admixtture with agents yielding polymerization initiating free radicals e.g. organic amines, mercaptans and triphenylmethane dyes as set forth in the said UK Patent Specifications nos. 997,396 and 1,047,569. A preferred agent is 2-mercaptobenzoxazole which has been disclosed for use in combination with 2,4,5-triarylimidazolyl dimers in the UK Patent Specification 1,345,434 filed July 7, 1971 by E.I.du Pont de Nemours.

Other and particularly suited free-radical producing photoinitiator compounds are oxime ester photopolymerization initiators containing at least one oxime ester group. Examples of these initiators are disclosed in US P 3,558,309 of Urbain Leopold Laridon and Gerard Albert Delzenne, issued January 26, 1971.

By the term "oxime ester photopolymerization initiator" is meant a compound containing at least one oxime ester group of the following structure : $-\overset{|}{C}=N-O-CO-R$ wherein R is an organic group. An alternative term for "oxime ester" is "O-acyloxime".

Specific oxime esters which can be used as photopolymerization initiator can be represented by the following formulae :

$$R^5 - \overset{\overset{\displaystyle R^4}{|}}{C} = N - O - R^6$$

and

$$R^5-\overset{\displaystyle R^4}{\overset{|}{C}}=N-O-R^7-O-N=\overset{\displaystyle R^4}{\overset{|}{C}}-R^5$$

wherein :

$R^4$ represents an alkyl group comprising 1 or 2 carbon atoms, an aryl group, an alkaryl group, an aralkyl group, a hydroxy-substituted aralkyl group, or an acyl group including a substituted acyl group,

$R^5$ represents a hydrogen atom, an alkyl group comprising 1 or 2 carbon atoms, an aryl group, or an acyl group including a substituted acyl group,

or wherein $R^4$ and $R^5$ together represent the necessary atoms to form with the adjacent carbon atom a cycloalkyl group, a phenanthrone group, or an indanone group,

$R^6$ represents an acyl group including a substituted acyl group, and

$R^7$ represents a diacyl group.

Preferably at least one of $R^4$ and $R^5$ is an acyl group including a substituted acyl group. The acyl groups for $R^4$, $R^5$ and $R^6$ are preferably acyl groups derived from aliphatic or aromatic carboxylic or sulphonic acids e.g. benzoyl, phenylsulphonyl, naphthoyl, anthraquinonyl- carbonyl, acetyl, propionyl, phenylacetyl, cinnamoyl, alkoxycarbonyl e.g. ethoxycarbonyl and N-substituted carbamoyl e.g. N-phenylcarbamoyl.

Particularly suitable oxime esters or O-acyloximes are the following :

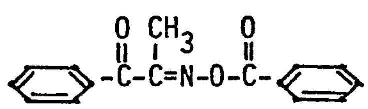

(A)

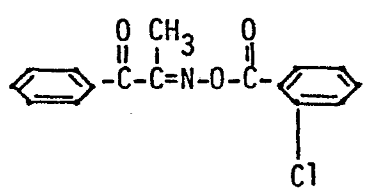

(B)

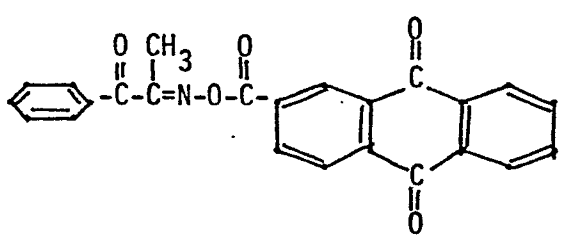

(C)

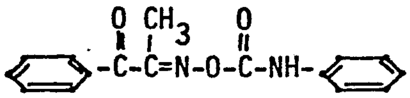

(D)

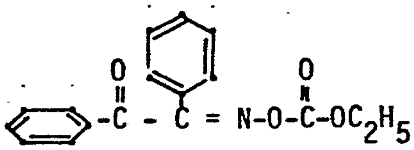

(E)

These oxime-ester photoinitiator compounds are particularly useful when applied in admixture with sensitizers e.g. those described in the European Patent Applications 0 009 832 filed August 25, 1978 by Agfa-Gevaert N.V. and 0 014 012 filed January 24, 1979 by Agfa-Gevaert N.V. e.g. Michler's ketone and carbostyril dye bases examples of which are the following :

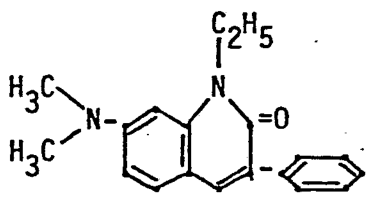

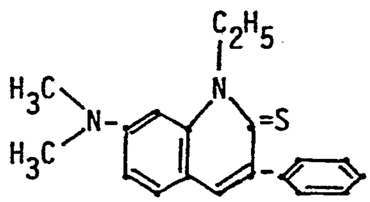

The amounts of oxime ester and of sensitizer added to the polymerizable monomer may vary between wide limits. Good results are obtained with 0.5-5 % by weight of sensitizer and 2.5-20 % by weight of oxime ester, preferably 1.0-2.5 % by weight of sensitizer and 10-17 % by weight of oxime ester, based on the total weight of polymerizable monomer.

The size of the dispersed photopolymerizable droplets including at least one photoinitiator compound ranges e.g. from 0.1 to 10 microns. Dispersion is improved with the aid of a surfactant. Useful surfactants are alkylnaphthalene sulfonic acid salts, organic

esters of phosphoric acid, benzyl alcohol, octyl alcohol, lauryl alcohol, sodium lauryl sulphate, sulphonated derivatives of fatty acid amides and the condensation products of octyl phenyl and sorbitan monolaurate with polyoxyethylene oxide. Low boiling solvents which are removed before coating the dispersion are likewise suitable aids to incorporate the water-insoluble polymerizable monomers in a hydrophilic colloid binder. Examples of such solvents are ethyl formate, ethyl acetate, propyl acetate, n-butyl acetate, ethyl butyrate, hydrocarbons e.g. benzene, chlorinated hydrocarbons e.g. methylene chloride and ethers e.g. diethyl ether.

The amount by weight of dispersed photopolymerizable material including the monomer(s) and photoinitiator(s) with respect to the hydrophilic binder may vary within broad ranges but is preferably within the weight ratio range of 0.1/1 to 10/1.

The thickness of the layer containing the dispersed monomer(s) is e.g. in the range of 0.1 µm to 25 µm.

The hydrophilic colloid binder for the dissolved or dispersed monomer and optionally for the development nuclei is preferably gelatin but other natural and synthetic water-permeable organic colloid binding agents can be used. Such agents include water-permeable polyvinyl alcohol and its derivatives, e.g. partially hydrolyzed polyvinyl acetates, polyvinyl ethers, and acetals. Useful polyvinyl acetals include polyvinyl acetaldehyde acetal and polyvinyl butyraldehyde acetal. Further are mentioned hydrophilic cellulose ethers and esters, alginic acid and polyvinyl pyrrolidone.

The development nuclei used in the image receiving layer which may be the photopolymerizable layer are generally of the kind known in the art e.g. those described in the book : "Photographic silver halide diffusion processes" by André Rott and Edith Weyde - The Focal Press; London and New York (1972) 54-56. Particularly suited are colloidal silver and the sulphides e.g. of silver and nickel and mixed sulphides thereof. The coverage of developing nuclei is in the same range as normally used in known DTR-materials. For example an amount in the range of 0.1 mg to 100 mg per sq.m of mixed nickel-silver sulphide nuclei proved to be very effective. The image receptor layer may include in the hydrophilic colloid binder any other additive known for use in DTR-receptor materials e.g. (a)

toning agent(s), a silver halide solvent, (a) developing agent(s), (an) opacifying agent(s) e.g. pigments, polymer latex particles e.g. polyethylacrylate, (an) optical brightening agent(s) and (a) hardening agent(s).

Suitable hardening agents are those known for the hardening of gelatin and are described e.g. in The Theory of the Photographic Process, by T.H.James, 4th ed., Macmillan Publishing Co., Inc. New York (1977) 77-84. The most commonly used hardening agent for the hardening of gelatin in photographic materials is formaldehyde, but other compounds such as dimethylol urea, glyoxal and chrome alum are likewise very active. The image-receiving layer is normally hardened to improve its mechanical strength. Hardening may also be effected by incorporating a latent hardener in that layer, whereby a hardener is released on applying the alkaline processing liquid.

The overall hardening to some degree of the image receiving layer and optionally also of an adjacent photopolymerizable layer improves the stability on storage and does not affect deleteriously the formation of the desired masker image.

The support of the image-receiving material of the present invention may be made of any material as long as it does not deleteriously affect DTR-processing and photopolymerization. Preference is given to paper supports, e.g. paper coated at one or both sides with an alpha-olefin polymer, e.g. polyethylene or baryta coated paper. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-alpha-olefin films such as polyethylene or polypropylene film.

The support is usually 0.05 to 0.15 mm in thickness. When the base is made of a transparent resin transparencies can be made which can be viewed by projection. The support can also be a metal support e.g. zinc, and especially aluminium. Excellently adhering silver images can be prepared by incorporating the developing nuclei in the pores of the external oxide layer of the metal.

For carrying out the silver complex diffusion transfer process the developing agents may be incorporated in the light-sensitive silver halide emulsion layer and/or the image-receiving layer or

other water-permeable layers adjacent thereto, as has been described e.g. in the DE-OS 2,853,711 filed December 13, 1978 by Agfa-Gevaert N.V., GB P 1,093,177 filed December 16, 1964 - 1,000,115 filed August 4, 1961 - 1,012,476 filed December 18, 1961 - 1,042,477 filed June 17, 1963 - 1,054,253 filed August 6, 1963 all of them by Gevaert Photo-Producten N.V., and in US P 3,985,561 of Louis Maria De Haes, Leon Louis Vermeulen, Hugo Karel Gevers, Stephan Jeanne Bongaerts and Paul Désiré Van Pee, issued October 12, 1976. The processing liquid accordingly used in the DTR-development stage can then be limited to a so-called alkaline activating liquid being a mere aqueous alkaline solution comprising no developing agent(s), which in that case are incorporated in the image-receiving layer and/or light-sensitive emulsion layer.

Suitable developing agents for the exposed silver halide are, e.g., hydroquinone and 1-phenyl-3-pyrazolidinone and p-monomethylaminophenol. The development or activating liquid contains in the process for forming a silver image through the silver complex diffusion transfer process a silver halide solvent, e.g., a complexing compound such as an alkali metal or ammonium thiosulphate or thiocyanate, or ammonia. Alternatively or in addition such complexing compound may be present in the image-receiving layer.

The silver halide emulsion layer may be any of the silver halide emulsion layers customarily applied in the silver complex diffusion transfer process. For the preparation of continuous tone images silver halide emulsions of the type described in the already mentioned US P 3,985,561 and DE-OS 2,853,711 may be used.

In the two-sheet system process of the present invention the support of the silver halide emulsion material may be a film or paper support of the type referred to hereinbefore for the image-receiving material.

Any of the commercially available silver halide emulsion materials for use in the silver complex diffusion transfer process can be used in the two-sheet system process of the present invention e.g. the COPYRAPID and COPYPROOF negative materials marketed by Agfa-Gevaert N.V. (COPYRAPID and COPYPROOF are registered trade marks). Representative examples of materials having a silver halide emulsion of the negative type suitable for use in conjunction with

the present photosensitive image receiving material are :

| | |
|---|---|
| COPYRAPID CRS-CRM | (for contact exposure) |
| COPYRAPID CRN | (for camera exposure) |
| COPYPROOF PPC | (for contact exposure e.g. in reflex for line work) |
| COPYPROOF PPN | (for camera exposure) |
| COPYPROOF CPC | (for contact exposure) |
| COPYPROOF CPN | (for camera exposure) |
| COPYPROOF CPTN | (for camera exposure in continuous tone reproduction) |

The exposure of the light-sensitive silver halide emulsion material and the diffusion transfer proceed preferably with, or in the apparatus commercially available therefor and of which several types have been described in the already mentioned book of A.Rott and E.Weyde.

Suitable radiation sources for the exposure of the photopolymerizable layer are sources emitting actinic light by which is meant here electromagnetic radiation including U.V. radiation and visible light in the wavelength range of 250-700 nm. Suitable light sources are therefore carbon arcs, mercury vapour lamps and U.V. fluorescent lamps, incandescent light bulbs and flash lamps.

In the monosheet materials used according to the process of the present invention the exposure of the silver halide emulsion layer should preferably be such that it does not substantially affect the exposure of the photopolymerizable layer and vice versa. For this purpose use can be made e.g. of the differences in photosensitivity of the silver halide grains and the photopolymerizable compositions, the differences in their spectral sensitivity and their arrangement in the photographic material by having a radiation-absorbing element between both e.g. a titanium dioxide layer, permitting independent exposure of both photosensitive layers.

The present invention is illustrated by means of the following examples but is not limited thereto. All parts and percentages are by weight unless otherwise stated.

Example 1

- Preparation of solution A

pentaerythritol tetraacrylate (monomer) 2.05 g

bis[2-(2'-chlorophenyl) 4,5-diphenyl-

| | |
|---|---|
| 4H-imidazolyl (4)] | 0.75 g |
| 2-mercaptobenzoxazole | 0.04 g |
| Michler's ketone | 0.04 g |
| methylene chloride | 8 ml |
| ethyl acetate | 2 ml |

- Preparation of solution B

The following ingredients were mixed :

gelatin 2.5 g

10 % aqueous solution of sodium salt of p-dodecylphenylsulphonic acid 0.7 ml

water 46.8 ml

The solution A was dispersed by high speed mixing into solution B and the organic solvents removed under reduced pressure at 55°C. To the obtained dispersed 0.35 ml of an aqueous colloidal dispersion (0.6 % by weight) of mixed silver nickel sulphide ($Ag_2S.NiS$) development nuclei were added.

The obtained dispersion was coated onto a polyethylene coated paper support at a wet coating thickness of 25 µm and dried for 2 min at 50°C.

The obtained photopolymerizable receptor material was used in conjunction with the COPYPROOF (registered trade mark) CPTN silver halide emulsion material for identity-portrait camera-exposure. After image-wise exposure the said silver halide emulsion material was processed in contact with the receptor material in a common DTR-processing apparatus containing an aqueous activator liquid having the following composition :

| | |
|---|---|
| water | 800 ml |
| tribasic sodiumphosphate-12-water | 75 g |
| sodium sulphite (anhydrous) | 40 g |
| potassium bromide | 0.5 g |
| sodium thiosulphate (anhydrous) | 20 g |
| 1-phenyl-5-mercaptotetrazole | 70 mg |
| water up to | 1000 ml. |

After a contact time of 45 s at 20°C the receptor material and silver halide emulsion material were separated and a first silver image was obtained on the receptor material.

The receptor material was rinsed with tap water.

Thereupon the receptor material was exposed to a line pattern with ultra-violet radiation for 30 s in an industrial photoprinter CHEMCUT (registered trade mark of Chemcut Corporation - USA) using 8 ultra-violet radiation emitting fluorescent lamps of 20 Watt placed at a distance of 12 cm from the receptor material. After that exposure no visible alteration could be detected in the receptor material.

Stabilization was carried out by rinsing for 1 min at 20°C the patternwise ultra-violet radiation exposed receptor material with a 1.5 % aqueous sodium hydroxide solution acting as a reagent for the monomer.

After said stabilization a fraudulent substitution of the first silver image was tried by bleaching said silver image with a bleaching solution containing a mixture of 4 parts of an aqueous solution of 240 g of sodium thiosulphate per litre and 1 part of an aqueous solution of 19 g of potassium hexacyanoferrate(III) per litre. The bleached receptor material was rinsed with tap water and dried.

The DTR-procedure was repeated starting with an other image-wise exposure of a new sheet of COPYPROOF (registered trade mark) CPTN silver halide emulsion material photographing a different subject and the new print DTR-processed to transfer the silver complex formed within the frame of the former picture on the bleached receptor material. The line pattern of the ultra-violet radiation exposure was now easily detectable by the eye and by an electronic optical density detecting photocell apparatus.

The maximum optical density of the original silver image obtained in the receptor material was 1.38 and the fog density was 0.11.

Maximum optical densities of the second silver image were measured in the previously U.V. exposed area and in the non-U.V. exposed area. The maximum optical densities (Dmax) were measured in a zone (I) wherein previously no image silver had been formed and in a zone (II) wherein previously a silver image had been formed.

| Area | (I) Dmax | (II) Dmax |
| --- | --- | --- |
| U.V. exposed | 0.81 | 0.85 |
| non U.V.-exposed | 1.08 | 1.10 |

Density differences (Δ Dmax) of (1.08-0.81) = 0.27 and (1.10-0.85) = 0.25 are easily detectable.

The fog density values in the previously U.V.-exposed area and in the previously non U.V.-exposed area were the same viz. 0.12.

Example 2

A photopolymerizable layer containing developing nuclei was prepared starting from the following coating composition :

| | | |
| --- | --- | --- |
| acrylamide | 1.5 | g |
| N,N-methylene bisacrylamide | 0.5 | g |

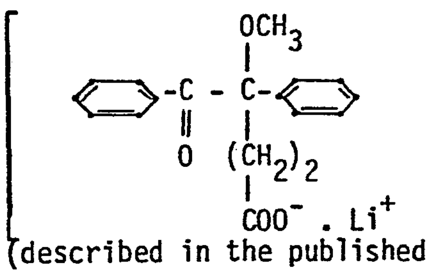

(described in the published Dutch patent application 71 06311)

| | | |
| --- | --- | --- |
| as photocatalyst A | 0.2 | g |
| 0.6 % aqueous colloidal dispersion of mixed silver nickel sulphide ($Ag_2NiS_2$) developing nuclei | 0.35 | ml |

The coating composition was applied at a wet coating thickness of 50 um to a polyethylene coated paper support and dried for 3 min at 45°C in a ventilated stove.

The obtained photopolymerizable receptor material was used in conjunction with the COPYPROOF (registered trade mark) CPTN silver halide emulsion material for identity-portrait camera-exposure and said silver halide emulsion material after image-wise exposure was processed in a common DTR-processing apparatus with an aqueous activator liquid as described in Example 1. After a contact time of 45 s at 20°C the receptor material and silver halide emulsion

material were separated and the receptor material rinsed for 1 min at 20°C with tap water. Thereupon the receptor material was soaked in the following solution :

| | | |
|---|---|---|
| acrylamide | 3 | g |
| N,N-methylene bisacrylamide | 1 | g |
| photocatalyst A | 0.8 | g |
| water | 100 | ml |

The receptor material was dried and pattern-wise exposed for 10 min in an industrial photoprinter DUPLIPHOT (registered trade mark of Agfa-Gevaert N.V. Belgium).

Stabilization was carried out by rinsing for 1 min at 20°C with a 1.5 % aqueous solution of sodium hydroxide. The maximum optical density of the original silver image was 1.44 and the fog density was 0.10.

After said stabilization the original silver image was bleached as described in Example 1 and the material rinsed with tap water.

The procedure was repeated starting with an other image-wise exposure on a sheet of COPYPROOF (registered trade mark) CPTN silver halide emulsion material photographing a different subject and the new print was DTR-processed to transfer the silver complex formed within the frame of the former picture on the bleached receptor material.

Maximum optical densities of the second silver image were measured in the previously U.V.-exposed area and in the non U.V.-exposed area. The maximum optical densities (Dmax) were measured in a zone (I) wherein previously no image silver had been formed and in a zone (II) wherein previously a silver image had been formed.

| Area | (I) Dmax | (II) Dmax |
|---|---|---|
| U.V.-exposed | 1.20 | 1.08 |
| non U.V.-exposed | 1.16 | 1.16 |

The fog values in the previously U.V.-exposed and non U.V.-exposed area were the same viz. 0.10.

Example 3

A photopolymerizable layer free from developing nuclei was prepared starting from the following coating composition :

| | |
|---|---|
| acrylamide | 1.5 g |
| N,N-methylene bisacrylamide | 0.5 g |
| a photocatalyst A of Example 2 | 0.2 g |
| 5 % aqueous solution of $F_{15}C_7$-$COONH_4$ (surface active agent) | 0.7 ml |

The coating composition was applied at a wet coating thickness of 25 µm to a commercial image receiving material COPYPROOF CPP (registered trade mark of Agfa-Gevaert N.V. Belgium) containing a surface layer including $Ag_2NiS_2$ developing nuclei in a gelatin binder.

The further procedure starting with the production of the original image by DTR-processing proceeded as described in Example 2. The maximum optical density of the original image was 1.52 and the fog density was 0.11.

Maximum optical densities of the second silver image were measured in the previously U.V.-exposed area and in the non U.V.-exposed area such with and without the stabilization treatment. The optical densities (Dmax) were measured in a zone (I) wherein previously no image silver had been formed and in a zone (II) wherein previously a silver image had been formed.

| Area | (I) Dmax | (II) Dmax |
|---|---|---|
| U.V.-exposed | | |
| without stabilization | 1.52 | 1.29 |
| with stabilization | 1.54 | 1.21 |
| non U.V.-exposed | | |
| without stabilization | 1.42 | 1.39 |
| with stabilization | 1.40 | 1.36 |

The fog density in the U.V.-exposed as well as in the non U.V.-exposed area had the value of 0.13.

Example 4

- Preparation of solution A

| | |
|---|---|
| pentaerythritol tetraacrylate | 2.05 g |
| bis [2-(2'-chlorophenyl)4,5-diphenyl-4H-imidazolyl(4)] | 0.75 g |
| 2-mercaptobenzoxazole | 0.04 g |
| Michler's ketone | 0.04 g |
| methylene chloride | 8 ml |
| ethyl acetate | 2 ml |

- Preparation of solution B

The following ingredients were mixed :

| | |
|---|---|
| gelatin | 2.5 g |
| 10 % aqueous solution of sodium salt of p-dodecylphenylsulphonic acid | 0.7 ml |
| water | 46.8 ml |

The solution A was dispersed by high speed mixing into solution B and the organic solvents removed under reduced pressure at 55°C.

The coating composition was applied at a wet coating thickness of 50 µm to a commercial image-receiving material COPYPROOF CPP (registered trade mark of Agfa-Gevaert N.V. Belgium) containing a surface layer including $Ag_2NiS_2$ developing nuclei in a gelatin binder.

The coated and dried image-receiving material was exposed patternwise with ultra-violet light for 30 s in the already mentioned CHEMCUT-photoprinter.

The thus exposed image-receiving material was used in conjunction with a COPYPROOF (registered trade mark) CPTN silver halide emulsion material that had been image-wise exposed in a portrait-camera and the combination of the two materials processed in a common DTR-processing apparatus with an aqueous activator liquid having the composition described in Example 1.

Density-measurements on the image-receiving material.

| Area | Dmax |
|---|---|
| U.V.-exposed area | 1.10 |
| non U.V.-exposed area | 1.40 |

The fog density in the U.V.-exposed as well as in the non U.V.-exposed area had the value 0.10.

The image-receiving material was then subjected to a stabilization treatment consisting of an overall U.V.-exposure.

Example 5

- Preparation of solution A

| | | |
|---|---|---|
| pentaerythritol tetraacrylate (monomer) | 2.05 | g |
| O-acyloxime (A) | 0.304 | g |
| 2-mercaptobenzoxazole | 0.04 | g |
| Michler's ketone | 0.03 | g |
| chloroform | 7 | ml |
| ethyl acetate | 3 | ml |

- Preparation of solution B

The following ingredients were mixed :

| | | |
|---|---|---|
| gelatin | 2.25 | g |
| saponine [11.7 % solution in water/ ethanol (4/1)] | 1 | ml |
| 10 % aqueous solution of sodium salt of p-dodecylphenylsulphonic acid | 0.5 | ml |
| water | 46.8 | ml |

The solution A was dispersed by high speed mixing into solution B and the organic solvents removed under reduced pressure at 55°C using a rotary evaporator.

To the obtained dispersion were added :

| | | |
|---|---|---|
| 4 % aqueous solution of formaldehyde | 1.25 | ml |
| 6 % by weight aqueous dispersion of mixed silver nickel sulphide development nuclei | 0.35 | ml |

The obtained dispersion was coated under yellow safelight onto a glossy polyethylene coated paper support at a wet coating thickness

of 50 µm and dried for 2 min at 50°C.

The obtained photopolymerizable receptor material was used in conjunction with the COPYPROOF (registered trade mark) CPTN silver halide emulsion material for identity-portrait camera-exposure. After image-wise exposure the said silver halide emulsion material was processed in contact with the receptor material in a common DTR-processing apparatus containing an aqueous activator liquid having the following composition :

| | | |
|---|---|---|
| water | 800 | ml |
| tribasic sodiumphosphate-12-water | 75 | g |
| sodium sulphite (anhydrous) | 40 | g |
| potassium bromide | 0.5 | g |
| sodium thiosulphate (anhydrous) | 20 | g |
| 1-phenyl-5-mercaptotetrazole | 70 | mg |
| water up to | 1000 | ml. |

After a contact time of 45 s at 20°C the receptor material and silver halide emulsion material were separated and a first silver image was obtained on the receptor material.

After rinsing for 1 min with water and drying the receptor material was exposed to a line pattern with ultra-violet radiation for 30 s in an industrial photoprinter CHEMCUT (registered trade mark of Chemcut Corporation - USA) using 8 ultra-violet radiation emitting fluorescent lamps of 20 Watt placed at a distance of 12 cm from the receptor material. After that exposure no visible alteration could be detected in the receptor material.

Stabilization was carried out by rinsing for 1 min at 20°C the patternwise ultra-violet radiation exposed receptor material with a 1.5 % aqueous sodium hydroxide solution acting as a reagent for the monomer.

The maximum optical density of the original silver image obtained in the receptor material was 1.68 and the fog density was 0.11.

After said stabilization a fraudulent substitution of the first silver image was tried by bleaching said silver image with a bleaching solution containing a mixture of 4 parts of an aqueous solution of 240 g of sodium thiosulphate per litre and 1 part of an aqueous solution of 19 g of potassium hexacyanoferrate(III) per litre. The bleached receptor material was rinsed with tap water and

dried.

The DTR-procedure was repeated starting with an other image-wise exposure of a new sheet of COPYPROOF (registered trade mark) CPTN silver halide emulsion material photographing a different subject and the new print DTR-processed to transfer the silver complex formed within the frame of the former picture on the bleached receptor material. The line pattern of the ultra-violet radiation exposure was now easily detectable by the eye and by an electronic optical density detecting photocell apparatus.

Maximum optical densities of the second silver image were measured in the previously U.V. exposed area and in the non-U.V. exposed area. The maximum optical densities (Dmax) were measured in a zone wherein previously a silver image had been formed.

| Area | Dmax |
|---|---|
| U.V. exposed | 1.31 |
| non U.V.-exposed | 1.51 |

Density differences (Δ Dmax) of (1.51-1.31) = 0.20 are easily detectable, particularly well in the continuous tone density range of 0.3 to 1 where even a density difference (ΔD) of 0.25 could be observed.

The fog density values in the previously U.V.-exposed area and in the previously non U.V.-exposed area were the same viz. 0.09.

CLAIMS

1. An imaging process comprising the steps :

(1) image-wise exposing a photopolymerizable layer of a first photographic material to form therein an image-wise change of permeability for dissolved silver complexes,

(2) image-wise exposing a silver halide emulsion layer forming part either of the said first photographic material, or of a second photographic material,

(3) developing the image-wise exposed silver halide emulsion layer in the presence of a developing agent and a silver halide solvent acting as a silver halide complexing agent,

(4) transferring by diffusion dissolved complexed silver halide from said emulsion layer to an image-receiving layer forming part of said first photographic material containing developing nuclei acting as physical development catalyst and which stand initially in water-permeable relationship with the photopolymerizable layer, and developing a silver image on the image-receiving layer by reduction of the transferred complexed silver halide, wherein step (1) is carried out either before or after the formation of the silver image in the said image-receiving layer.

2. An imaging process according to claim 1, wherein the said photopolymerizable layer contains the said developing nuclei and thus also forms the said image-receiving layer.

3. The process of claim 1 or claim 2 comprising the steps :

(1) providing a photographic negative working silver halide emulsion material,

(2) providing a separate image-receiving material suitable for carrying out the silver complex diffusion transfer reversal process and containing developing nuclei dispersed in a continuous water-permeable binder medium of a water-permeable photopolymerizable layer or containing said nuclei adjacent said photopolymerizable layer in water-permeable relationship therewith,

(3) image-wise exposing the photographic negative working silver halide emulsion material,

(4) developing the image-wise exposed silver halide emulsion material and contacting the developed exposed silver halide emulsion

material with the image-receiving material in the presence of an alkaline liquid containing the silver halide complexing agent and in the presence of at least one developing agent thereby transferring unexposed and complexed silver halide by diffusion into the image-receiving material to produce therein a silver image,

(5) separating the silver halide emulsion material from the receiving material, and

(6) before or after producing a silver image in the image-receiving material information-wise exposing the photopolymerizable layer to change information-wise the permeability of said layer for dissolved complexed silver halide.

4. The process of any of claims 1 to 3, characterized in that the water-permeable photopolymerizable layer includes a homogeneous mixture of a hydrophilic colloid binder and a water-soluble ethylenically unsaturated monomeric component dissolved in said binder, said mixture having uniformly distributed therethrough a photopolymerization initiator for initiating on photoexposure with actinic light the polymerization of said monomeric component.

5. The process of any of claims 1 to 4, characterized in that the image-wise exposure of the photopolymerizable layer precedes the image formation in the image-receiving layer and after the said image formation the photopolymerizable layer is overall exposed to actinic radiation.

6. The process of any of the claims 1 to 5, characterized in that the image-wise exposure of the photopolymerizable layer proceeds after the image-formation in the image-receiving layer and is followed by removal of still polymerizable monomer with a reagent or solvent therefor, by inactivating or extracting photoinitiator contained in the photopolymerizable layer, or by incorporating a photopolymerization inhibitor in the photopolymerizable layer.

7. The process of claim 2, characterized in that the photopolymerizable layer is applied as a covering layer over the development nuclei-containing image-receiving layer, the image-wise exposure of the photopolymerizable layer proceeds after the image-formation in the image-receiving layer and the said exposure is followed by washing-off still water-soluble or alkali-soluble

portions of the photopolymerizable layer.

8. An image-receiving material suitable for carrying out the silver complex diffusion transfer reversal process, characterized in that said material contains a support coated with a hydrophilic colloid layer containing developing nuclei and in water-permeable relationship therewith a photosensitive water-permeable covering layer including a homogeneous mixture of a hydrophilic colloid binder and a water-soluble ethylenically unsaturated monomeric component dissolved in said binder, said mixture having uniformly distributed therethrough a photoinitiator for initiating on photoexposure with actinic light the polymerization of said monomeric component.

9. An image-receiving material suitable for carrying out the silver complex diffusion transfer reversal process, characterized in that said material contains a support coated with a hydrophilic colloid layer containing developing nuclei and in water-permeable relationship therewith a photosensitive water-permeable covering layer including a hydrophilic colloid binder having uniformly dispersed therethrough a phase containing (1) at least one water-insoluble ethylenically unsaturated monomer being capable of forming a polymer by free-radical initiated chain-propagating addition polymerization, and (2) at least one free-radical producing photoinitiator compound or composition activatable by actinic light.

10. An image-receiving material suitable for carrying out the silver complex diffusion transfer reversal process, characterized in that said material contains a support coated with a photosensitive water-permeable layer including a hydrophilic colloid binder having uniformly dispersed therethrough developing nuclei and a phase containing

(1) at least one water-insoluble ethylenically unsaturated monomer being capable of forming a polymer by free-radical initiated chain-propagating addition polymerization and

(2) at least one free-radical producing photoinitiator compound or composition activatable by actinic light.

11. The image-receiving material of claim 8, characterized in that the monomeric components are water-soluble addition polymerizable ethylenically unsaturated vinyl or vinylidene compounds.

12. The image-receiving material of claim 9 or 10, characterized

in that the water-insoluble ethylenically unsaturated monomer is an unsaturated ester of a polyol.

13. The image-receiving material of any of the claims 9 to 12, characterized in that the photoinitiator is an O-acyloxime.

14. An image-receiving material comprising on a transparent support in the order given or in reversed order :

(1) a water-permeable photopolymerizable layer of which the permeability for dissolved silver complexes can be changed image-wise by image-wise exposure thereof and containing development nuclei for complexed silver halide, or
   - (1a) a layer containing development nuclei for complexed silver halide, and
   - (1b) a water-permeable photopolymerizable layer of which the water-permeability can be changed image-wise by image-wise exposure thereof,

(2) an opaque layer in water-permeable relationship with the photopolymerizable layer, and

(3) a silver halide emulsion layer.

15. The image-receiving material of any of the claims 8 to 14, characterized in that the hydrophilic colloid layer containing developing nuclei contains (a) an additive of the group of toning agent(s), a silver halide solvent, (a) developing agent(s), (a) hardening agent(s), (an) opacifying agent(s) and (an) optical brightening agent(s).

0057947

European Patent Office

# EUROPEAN SEARCH REPORT

Application number

EP 82 20 0059

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| D,A | US-A-3 236 644 (GILMAN et al.) *Column 1, line 56 - column 4, line 59; examples; claims* --- | 1 | G 03 C 5/54<br>G 03 C 1/68<br>G 03 C 1/46<br>G 03 C 5/00 |
| A | US-A-3 255 002 (ROGERS) *Column 2, lines 19-48; column 4, lines 21-73; examples; claims* --- | 1 | |
| A | US-A-3 861 911 (LUEBBE) *Claims* --- | 1 | |
| A | FR-A-1 478 018 (POLAROID) *Page 4, right-hand column, lines 23-43; claims* & GBA 1151771 --- | 1 | |
| A | US-A-3 679 409 (BUCKLER) *Column 8, lines 3-55; claims* ----- | 1 | TECHNICAL FIELDS SEARCHED (Int. Cl. 3) |
| | | | G 03 C 5/54<br>G 03 C 5/08<br>G 03 C 1/68<br>G 03 C 1/46<br>G 03 C 5/00<br>G 03 F 7/02 |

The present search report has been drawn up for all claims

| Place of search | Date of completion of the search | Examiner |
|---|---|---|
| THE HAGUE | 29-03-1982 | AMAND J.R.P. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons

& : member of the same patent family, corresponding document

EPO Form 1503. 03.82